# EUROPEAN PATENT APPLICATION

(11) **EP 0 571 889 A2**
(43) Date of publication of application: **01.12.1993**
(21) Application number: 93108173.1
(22) Date of filing: 19.05.1993
(51) Int. Cl.: H02J 3/14, G01R 21/00, G01R 21/133

(54) **Electric load controlling device**

(30) Priority: 29.05.1992 ES 9201115
(71) Applicant: ALCATEL STANDARD ELECTRICA, S.A., E-28045 Madrid (ES)
(72) Inventor: Alfonso Ronda, Jose Antonio, E-28044 Madrid (ES); Cid Vila, Ismael, E-28027 Madrid (ES)
(74) Representative: Pohl, Herbert, Dipl.-Ing

(57) **Abstract**

It permits optimisation of power consumption for different electricity rates, as well as the updating of the latter automatically.

It incorporates a rate module (1) which holds the time scheduling tables and the calendar defining the different electricity rates, which is connected to a decision module (5) which, in turn, is connected to a clock module (2) that holds the current time and date.

It includes a communications module (3) which serves to receive the information sent by a remote centre over a communications line (8), and which is connected to the clock module (2), to the rate module (1) and to the decision module (5).

The decision module (5) is also connected to a driver module (6) that is connected to a set of driver elements (A1, A2,...,An) each of which, in turn, is connected to a corresponding contactor (C1, C2,..., Cn) in order to connect or disconnect the corresponding section of the electrical installation (I1, I2,...,In) from the data obtained from the clock module (2), from the rates table and from pre-established decision criteria.

The decision module (5) is connected to a display module (7) and to a keyboard module (4) in order to be able to program manually and display the various data introduced.

## Description

### OBJECT OF THE INVENTION

The invention, as already stated in the title of this document, concerns an electric load controlling device, the object of which is to optimise the consumption of electric power in accordance with any of the possible rates contracted by the customer, as well as to permit the automatic updating of the rates when these come into force or when they are changed.

Consequently, the invention is applicable to electric power distribution networks, in which the electric utility offers the user the possibility of selecting among different types of rates.

### BACKGROUND TO THE INVENTION

A wide range of programmable controllers is known at present; their structure and operation are similar to that of watering controllers. These controllers are employed to adapt the consumption according to a schedule set by the user, and also they can optimise the consumption for certain types of rates. In all cases, they have to be manually programmed and, therefore, any change of applicable rate has the inconvenience of requiring a change of equipment or tedious manual reprogramming to be carried out at the location where this equipment is installed.

Within the types of rates, there are some (seasonal rates) that take into account an official calendar, that is changed every year, in which consideration is given to several types of day, local and general holidays, weekends, etc.

Conventional equipments do not have the capability to control these types of rates.

### TECHNICAL PROBLEM TO BE OVERCOME

Consequently the technical problem to be solved consists in optimising the consumption of electric power in accordance with any of the possible rates contracted by the customer, and automatically updating the rates when they come into force or when they are changed.

### CHARACTERISATION OF THE INVENTION

To overcome the inconveniences mentioned above, the invention is characterised in that it includes a communications module which serves to receive the information sent by a remote centre over a communications line, and which is connected to a clock module, to a rate module and to a decision module. The rate module, which holds the time scheduling tables and the calendar defining the different electricity rates, is also connected to the decision module which, in turn, is connected to the clock module, which holds the current date and time.

Another characteristic of the invention is that the decision module is also connected to a driver module, and sets up the different sections of the installation which have to be electrically live, based on the data obtained from the clock module, from the rates table held in the rate module, and from pre-established decision criteria.

Moreover, the invention has the characteristic that the driver module is also connected to a set of driver elements in order to control their connection/disconnection status. Each driver element is also connected to a corresponding contactor to make or break the contactor and therefore connect or disconnect the corresponding section of the electrical installation.

Another characteristic of the invention is that it has a display module connected to the decision module which sends it information on the state of the driver elements, date and time, and available and selected rates.

It is also characterised in that it has a keyboard module connected to the decision module, to the rate module and to the clock module, permitting the user to inform the equipment the rate(s) contracted and to set up a consumption schedule, set the clock module time, and manually change the tables in the rate module. All the data introduced through the keyboard module are presented on the display module.

Consequently by means of the structure of the invention it is possible to benefit from any type of rate available, including seasonal ones, from the moment the contract is signed.

In addition it permits the user, to his advantage, to maintain the time scheduling table and the calendar that define the different rates in an updated status, either through the communications module, as soon as they come into force, or manually through the keyboard module.

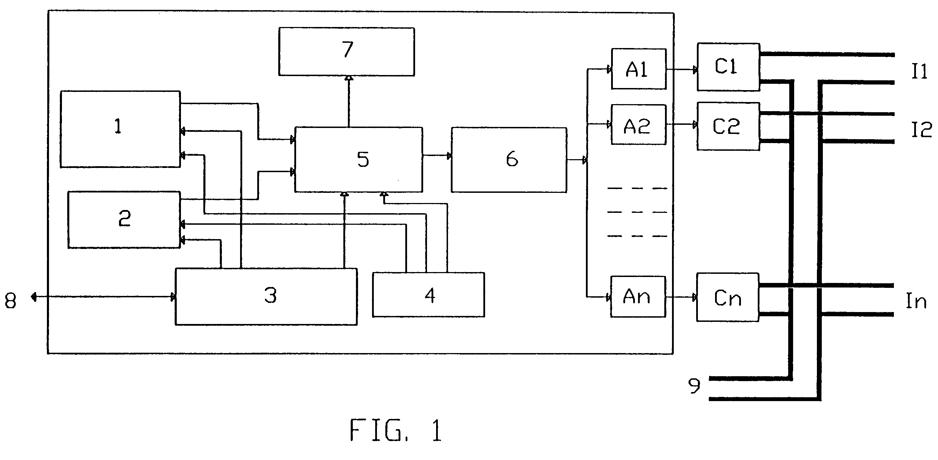

Next, in order to provide a better understanding of this document and forming an integral part thereof, a single figure is attached in which, by way of illustration and in no way limiting, the object of the invention is shown.

### BRIEF FOOTNOTE TO THE FIGURE

In the single figure, a functional diagram is given of the electric load controlling device object of the invention.

### DESCRIPTION OF THE INVENTION

A description of the invention is given below based on the figure mentioned above.

The invention is applicable to electric power distribution networks in which the electric utility offers several types of rates to the customer. The installation is divided into different sections I1, I2,...,In, which are operated by the electric load controlling device of the invention, with the object of optimising the consumption of electric power according to any one of the possible rates contracted by the customer. At the same time, it permits these rates to be updated when they come into force or whenever they are changed.

To make possible the implementation of these objectives, the invention incorporates a rate module 1 in which is stored the time scheduling table and the calendar that define the different electricity rates, and which is connected to the decision module 5 which, in turn, is connected to the clock module 2 that indicates the current time and date.

In addition, the decision module 5 is connected to a driver module 6 that is linked to a set of driver elements A1, A2,...,An, which, in turn, are connected to their corresponding contactors C1, C2,...,Cn, that control the different sections of the electrical installation I1, I2,...,In.

In addition, the invention has a communications module 3 that is connected to the decision module 5, to the rate module 1, to the clock module 2, and to a communications line 8.

The decision module 5 is connected, also, to a keyboard module 4 and to a display module 7.

As has already been mentioned, the rate module 1 holds the time scheduling table and the calendar that define the different rates and that can be updated from a remote point via the communications module 3, which collects the information on new time scheduling tables and calendars, or else from the keyboard module 4. This keyboard module 4 also permits the user to indicate to the equipment what rate has to be applied or to set the consumption pattern.

Either from the communications module 3, or from the keyboard module 4, it is possible to set the time of the clock module 2, adjusting it to the various changes in official time, or to restart it, or because of a fault.

The decision module 5 has on-board intelligence that controls the driver module 6 from the data obtained from the clock module 2 and from the rate that has to be applied according to the content of the rate module 1.

The driver module 6, from the instructions of the decision module 5, controls at all times the status of the set of drivers A1, A2,..., An.

The drivers A1, A2,...,An, consists of assemblies of devices that can each make or break voltage-free contacts to permit the connection or disconnection of the contactors C1, C2,...,Cn and, consequently, the corresponding section of the electrical installation I1, I2,...,In.

The display module 7 shows the user all the information pertinent to the status of each of the drivers A1, A2,...,An, as well as the rates available and the selected rate, the date and time, and the different data introduced through the keyboard module 4.

Having described the structure and facilities of each of the modules that comprise the invention, the different operating modes that the user may select are described.

The user can select between two operating modes:
1.- Optimising the consumption of electric power in accordance with the contracted rate.
2.- According to his own pattern, introduced through the keyboard module 4.

In the first operating mode, a series of consumption zones are defined. Currently, in Spain, there are five authorised zones termed Triple, Peak, Flat, Dip and Half, arranged from greatest to least cost. In this case there will be five drivers A1, A2, A3, A4 and A5. Each driver controls a section of the electrical installation I1, I2,...,I5, that will be fed according to the active consumption zone at a given time and the following table.

| **ACTIVE ZONE** | **DRIVERS OPERATED** |
|---|---|
| TRIPLE | A1 |
| PEAK | A1, A2 |
| FLAT | A1, A2, A3 |
| DIP | A1, A2, A3, A4 |
| HALF | A1, A2, A3, A4, A5 |

The active consumption zone is calculated periodically with the data from the time scheduling table and the calendar stored in the rate module 1. This calculation is also made when the time is reset or a new calendar or time scheduling table is received.

On the other hand, if the user has selected the second operating mode, the drivers A1, A2,...,A5 shall be enabled or inhibited according to the pattern introduced.

## Claims

1. **ELECTRIC LOAD CONTROLLING DEVICE**, **characterised:**
- in that it includes a communications module (3) which serves to receive the information sent by a remote centre over a communications line (8), which is connected to a clock module (2), to a rate module (1), and to a decision module (5);
- in that the rate module (1), which holds the time scheduling tables and the calendar defining the different electricity rates, is also connected to the decision module (5);
- in that the clock module (2), that holds the current time and date, is also connected to the decision module (5);
- in that the decision module (5) is also connected to a driver module (6), and sets up the sections in the installation (I1, I2,..., In) that have to be enabled, based on the data obtained from the clock module (2), from the rates table held in the rate module (1) and from pre-established decision criteria;
- in that the driver module (6) is also connected to a set of driver elements (A1, A2,...,An) in order to control their connection/disconnection status; and
- in that each driver element (A1, A2, ..An) is also connected to a corresponding contactor (C1, C2,...,Cn) to make or break the contactor and therefore connect or disconnect the corresponding section (I1, I2,...,In) of the electrical installation.

2. **ELECTRIC LOAD CONTROLLING DEVICE** according to claim 1, **characterised** in that it also has a display module (7) connected to the decision module (5) which sends it information on the state of the driver elements, date and time, and available and selected rates.

3. **ELECTRIC LOAD CONTROLLING DEVICE** according to claims 1 and 2, **characterised** in that it also has a keyboard module (4) that is connected to the decision module (5), to the rate module (1) and to the clock module (2), and which permits the user to inform the equipment of the rate(s) contracted and to set up a consumption schedule, set the time of the clock module (2), and manually change the tables in the rate module (1); all the data introduced through the keyboard module (4) being presented on the display module (7).
